# EUROPEAN PATENT APPLICATION

(11) **EP 4 760 271 A1**
(43) Date of publication of application: **17.06.2026**
(21) Application number: 24219141.9
(22) Date of filing: 11.12.2024
(51) Int. Cl.: G01R 11/04, G01R 11/24

(54) **AN ELECTRICITY METER**

(71) Applicant: Aidon Oy, 40100 Jyväskylä (FI)
(72) Inventor: SIEVÄNEN, Aleksi, 40100 Jyväskylä (FI); LOHVANSUU, Juha, 40100 Jyväskylä (FI)
(74) Representative: Berggren Oy

(57) **Abstract**

The invention relates to an electricity meter. It comprises terminals (16) for inlet and outlet power cables. The terminals comprise screws (18) for attaching the power cables. The electricity meter also comprises a removeable cover (35) to cover the terminals. The removeable cover is arranged so that it can be sealed. The electricity meter comprises also a terminal module (15) comprising said terminals inside. The terminal module has a front plate having holes (17) in order to rotate said screws. The terminal module also comprises a moveable protection plate (20) partly inside the terminal module. The protection plate is arranged to cover the holes in a first position and arranged not to cover the holes in a second position. The protection plate is also arranged to be sealed in the first position.

## Description

### Field of technology

The invention relates to electricity meters which are designed to meter power consumption of a house / real estate, and other possible information.

### Prior art

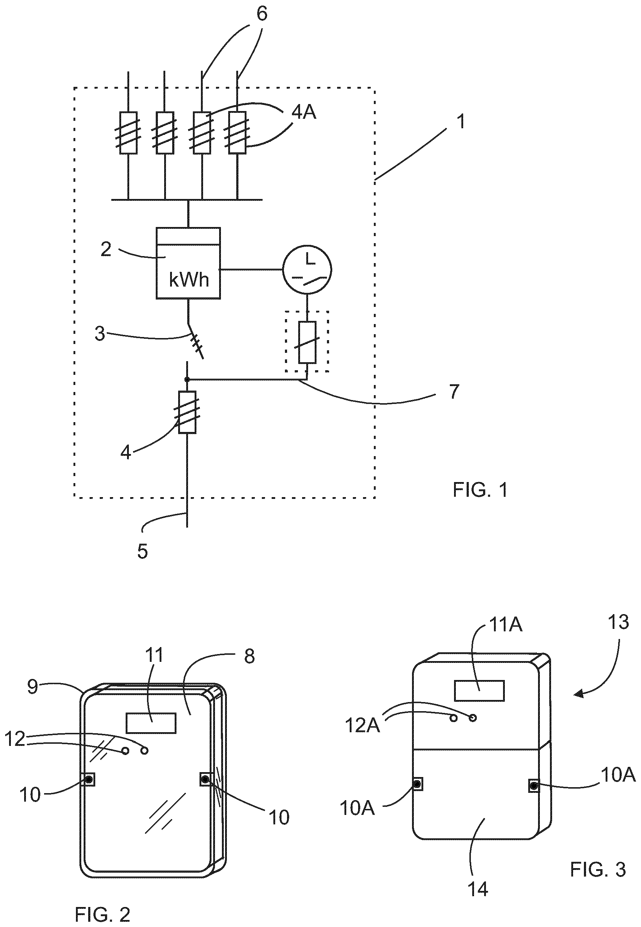

Figure 1 shows a schematic example of a metering board 1. Incoming distribution lines 5 (three phases), i.e. inlet cables from a power distribution network, are connected to fuses/circuit breakers 4, which in turn are connected to a main switch 3, the main switch is connected to an electricity meter 2, which is also connected to supply lines 6 of a house or real estate, i.e. outlet power cables. The supply lines are provided with fuses/circuit breakers 4A as well. In order to secure that the electricity meter 2 works also if the main switch is switched off, the electricity meter has a parallel supply 7. In this way the electricity meter can record metering information during a fault situation where the main switch 3 is switched off.
Figure 2 shows an example of an electricity meter 8, which is covered by a removeable cover 9. Here, in this example the removeable cover is illustrated as a transparent, but it can also be non-transparent. The removeable cover and the electricity meter comprise fasteners 10 which can be sealed. So, only electricians having a license, like electricians from a power electricity company, are allowed to break the seals and remove the cover 9 in order to make installation work. Usually, the electricity meter is also provided with a display 11 and a control button/s 12. So, the removable cover may comprise holes for at least to the control button/s. The electricity meter 8 comprises terminals for inlet and outlet power cables. The terminals comprise screws for attaching the power cables.
Figure 3 shows another example of a known electricity meter 13. In this embodiment the removeable cover 14 covers the terminals for the inlet and outlet power cables, but not the whole meter 14. The removeable cover and the electricity meter comprise fasteners 10A which can be sealed. The meter is also provided with a display 11A and a control button/s 12A. As can be seen the removeable cover can be realized in different ways.

By removing the removeable cover the terminals or parts of the terminals are visible and they can be touched. This is a safety risk, since the terminals have high voltage, when the main switch of the metering board is on. Further, making local installations within the electricity meter requires a license from the power electricity company.

### Short description

The object of the invention is to make a solution in order to make local installation work within the electricity meter safe and easier. The object is achieved in a way described in the independent claim. Dependent claims illustrate different embodiments of the invention.

An electricity meter according to the invention comprises terminals for inlet and outlet power cables. The terminals comprise screws for attaching the power cables. The electricity meter also comprises a removeable cover to cover the terminals. The removeable cover is arranged so that it can be sealed. The electricity meter comprises also a terminal module comprising said terminals inside. The terminal module has a front plate having holes in order to rotate said screws. The terminal module also comprises a moveable protection plate partly inside the terminal module. The protection plate is arranged to cover the holes in a first position and arranged not to cover the holes in a second position. The protection plate is also arranged to be sealed in the first position.

### List of figures

In the following, the invention is described in more detail by reference to the enclosed drawings, where
- Figure 1: illustrates an example of metering board,
- Figure 2: illustrates an example of a known electricity meter,
- Figure 3: illustrates another example of a known electricity meter,
- Figure 4: illustrates an example of a terminal module according to the invention in its first position,
- Figure 5: illustrates an example of a terminal module according to the invention in its second position,
- Figure 6: illustrates an example of a sealing fastener,
- Figure 7: illustrates an example of a counterpart sealing fastener,
- Figure 8: illustrates an example of a terminal module with a circuit board module,
- Figure 9: illustrates an example of an electricity meter without a removeable cover,
- Figure 10: illustrates an example of an electricity meter with a removeable cover, and
- Figure 11: illustrates a bottom view of an electricity meter according to the invention without a removeable cover.

### Description of the invention

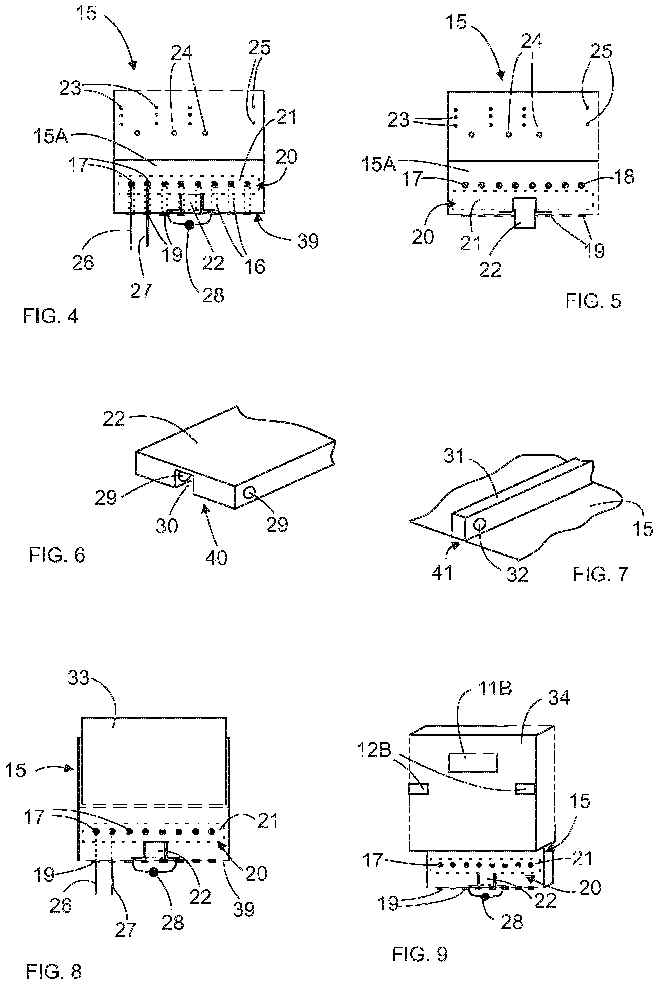

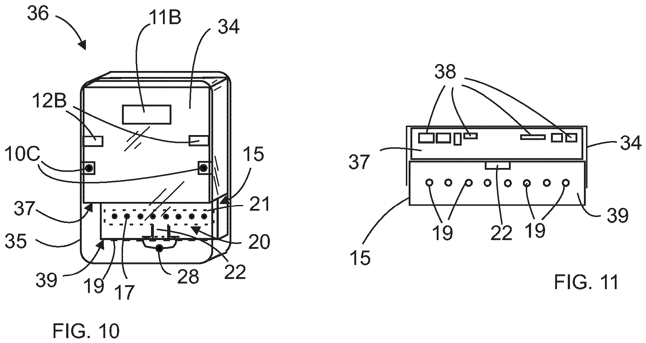

Figures 4, 5 and 8 illustrate a terminal module 15 according to the invention. Figures 6 and 7 show an example of a sealing fastener 40 and a counterpart sealing fastener 41. Figures 9 and 10 illustrate an example of an electricity meter with and without a removeable cover 35. Figure 11 shows a bottom view of the electricity meter according to the invention.

An electricity meter 36 according to the invention comprises terminals 16 for inlet and outlet power cables 26, 27. The terminals comprises screws 18 for attaching the power cables. The electricity meter also comprises a removeable cover 35 (figure 10) to cover the terminals 16. The removeable cover is arranged so that it can be sealed. The electricity meter 36 comprises also a terminal module 15 (figures 4, 5 and 8) comprising said terminals 16 inside. The terminal module has a front plate 15A having holes 17 in order to rotate said screws 18.

The terminal module 15 also comprises a moveable protection plate 20 partly inside the terminal module. The protection plate is arranged to cover the holes 17 in a first position and arranged not to cover the holes in a second position. The protection plate 20 also being arranged to be sealed in the first position.

Figure 4 illustrates an example of a terminal module 15 according to the invention in its first position wherein the protection plate 20 covers the holes 17. So, when the removeable cover 35 has been taken away, the protection plate protects an electrician from getting an electric shock from the screws of the terminals.

Figure 4 shows also a wire seal 28, which a licenced electrician is allowed to break. Breaking the seal may be needed if the connections of inlet and/or outlet cables 26, 27 are checked or for other reasons like replacing the cables. When the seal has been broken the protection plate 20 can be moved into the second position wherein the holes 17 are not covered and the ends of the screws are visible. Figure 5 shows the second position. So, the protection plate is moveable.

The terminals 16 for the cables comprises the screws 18 to attach the cables, and openings 19 to insert the ends of the cables into the terminals. The holes, as said, are on the front plate 15A, and the openings 10 are on the bottom side 39 of the terminal module. Figure 4 illustrates only one inlet cable 26 and outlet cable 27 for one phase (L1). However, as can se seen, the terminal module has the terminals for other phases (L2 and L3) as well, and also to a neutral line.

In the embodiment of figures 4 and 5 the protection plate 20 comprises a longitudinal part 21 to cover the holes 17 in the first position and a projection part 22 from the longitudinal part. The projection part is visible on the terminal module 15, and the projection part comprises sealing fastener 40. The terminal module 15, more precisely it's body, comprises a counterpart sealing fastener 41. In the figures the part of the protection plate (the longitudinal part 21) and the terminals 16 are illustrated in dashed lines because they are mostly inside the terminal module.

Figure 6 shows an embodiment of the sealing fastener 40 of the projection part 22. Figure 7 shows an embodiment of the counterpart sealing fastener 41 of the terminal module 15. The sealing fastener 41 comprises a through hole 29 and a groove 30. The through hole is across groove. The counterpart sealing fastener 41 comprises a ridge 31 having a transversal hole 32 through the ridge. The through hole 29 and the transversal hole 32 being in line in the first position. In the first position a wire seal 28 can be set via the through hole 29 and the transversal hole 32 for sealing the protection plate 20 in place. Figures 6 and 7 show one example to realize the sealing fastener and the counterpart sealing fastener. Another way is, for example, that the projection part has a through hole and the terminal module (more precisely it's body) has hole/ to be aligned with the through hole of the projection part.

Figures 4 and 5 show also connections 23, 24, 25 in order to attach a circuit board module 33 on the terminal module 15. Figure 8 illustrates a schematic example of the circuit board module on the terminal module. The circuit board module comprises metering electronics. The circuit board module attached to the terminal module 15 is under a casing 34, which protects and covers the circuit board and partly the terminal module. Figure 9 illustrates an example of the casing 34. The casing can be made so that it has positions for a display 11B and control buttons 12B. It is also possible that the circuit board module 38 comprises one circuit board or two circuit boards connected to each other. The use of two circuit boards can be convenient so that one circuit board is for analog circuits and the other circuit is for digital circuits.

Figure 10 illustrates an example of the electricity meter 36 with the removeable cover 35. As said, the cover has the sealing parts10C so that it can be sealed. If sealed, only a licenced electrician is allowed to remove the cover 35. The example of figure 10 covers the terminal module and the casing 34, but it may be possible to realize the removeable cover 35 so that it covers only a part of the terminal module. So, the removeable cover can be realized in many ways. Since, the terminal module 15 has the protection plate, which can be sealed, the sealing of the removeable cover is not needed if the authority of the electricity meter (a power electricity company) considers it unnecessary.

The electricity meter according to an inventive embodiment comprises interfaces 38 to add additional components and/or additional communication. The interfaces are connected to the circuit board module 38. The additional components are, for example, power supply relays, a connection for an external antenna, RJ12 ports, a serial communication port, pulse outputs, HAN (Home Area Network) port and so on.

It is convenient that the casing 14 comprises a bottom plate 37 having said interfaces 38. The interfaces 38 are covered by the removeable cover 35 and therefore are accessible after removing the removeable cover. Figure 11 show a schematic bottom view of the electricity meter 36 without the removeable cover. The figure illustrates the bottom side 39 of the terminal module 15 and the bottom plate 37 of the casing 14.

If the removeable cover 35 is not sealed any electrician can do local installations on the electricity meter, like adding relays, and an external antenna etc. safely, since the protection plate 20 covers the ends of the screws 18 having high voltage. In other words, there is no need to request a licenced electrician from the power electricity company. The electrician who makes local installations in a house / real estate can also make installations on the electricity meter 36 which are needed for the local installations. Further, it may even be possible that the main switch 3 of the metering board 1 is not needed to switch off.

As can be seen the invention can be realized in many ways. It is evident from the above that the invention is not limited to the embodiments described in this text but can be implemented in many other different embodiments within the scope of the independent claims.

## Claims

1. An electricity meter (36) comprising terminals (16) for inlet and outlet power cables (26, 27), the terminals comprising screws (18) for attaching the power cables, the electricity meter also comprising a removeable cover (35) to cover the terminals (16), which removeable cover is arranged so that it can be sealed, **characterised in that** electricity meter (36) comprises a terminal module (15) comprising said terminals (16) inside, the terminal module has a front plate (15A) having holes (17) in order to rotate said screws (18),
the terminal module (15) also comprising a moveable protection plate (20) partly inside the terminal module, which protection plate is arranged to cover the holes (17) in a first position and arranged not to cover the holes in a second position, the protection plate (20) also being arranged to be sealed in the first position.

2. An electricity meter according to claim 1, **characterised in that** the protection plate (20) comprises a longitudinal part (21) to cover the holes (17) in the first position and a projection part (22) from the longitudinal part, the projection part being visible on the terminal module (15), and comprising sealing fastener (40), the terminal module (15) comprising a counterpart sealing fastener (41).

3. An electricity meter according to claim 2, **characterised in that** the sealing fastener (41) comprises a through hole (29) and a groove (30), the through hole being across groove, and the counterpart sealing fastener (41) comprising a ridge (31) having a transversal hole (32) through the ridge, the through hole (29) and the transversal hole (32) being in line in the first position.

4. An electricity meter according to claim 1, 2 or 3, **characterised in that** it comprises interfaces (38) to add additional components and/or additional communication, the interfaces (38) being covered the removeable cover (35) and being accessible after removing the removeable cover.

5. An electricity meter according to claim 4, **characterised in that** it comprises a circuit board module (33), comprising metering electronics, the circuit board module being attached to the terminal module (15) and being under a casing (34), the interfaces being connected to the circuit board module (38).

6. An electricity meter according to any of claims 1 - 5, **characterised in that** the circuit board module (38) comprises two circuit boards connected to each other.

7. An electricity meter according to any of claims 1 - 6, **characterised in that** casing (14) comprises a bottom plate (37) having said interfaces (38).
